# EUROPEAN PATENT SPECIFICATION

(11) **EP 4 227 995 B1**
(45) Date of publication and mention of the grant of the patent: **11.09.2024**
(21) Application number: 22155917.2
(22) Date of filing: 09.02.2022
(51) Int. Cl.: H01L 25/07, H01L 25/18, H01L 23/00, H01L 25/00, H01L 21/50

(54) **POWER ELECTRONICS MODULE AND METHOD FOR ITS MANUFACTURING**
LEISTUNGSELEKTRONIKMODUL UND VERFAHREN ZU DESSEN HERSTELLUNG
MODULE D'ÉLECTRONIQUE DE PUISSANCE ET SON PROCÉDÉ DE FABRICATION

(43) Date of publication of application: 16.08.2023
(73) Proprietor: Hitachi Energy Ltd, 8050 Zürich (CH)
(72) Inventor: EHRBAR, Roman, 8037 Zürich (CH); LUDWIG, Maxime, 8047 Zürich (CH)
(74) Representative: Epping - Hermann - Fischer

(56) References cited:
- EP-A1- 2 804 209
- DE-A1- 19 735 531
- US-A- 6 002 163
- US-A1- 2018 350 780
- US-A1- 2019 006 260

## Description

The present disclosure relates to a power electronics module comprising a substrate with at least a first metallization area and a first group of power electronic devices. The present disclosure further relates to a method for manufacturing such a power electronics module.

Power electronics modules comprising a plurality of power electronic devices are used in many different application areas. In particular, in the area of power electronics, a plurality of power semiconductor chips may be connected in parallel to form a power electronics module with a relatively high current rating.

DE 197 35 531 A1 relates to a power semiconductor device module having a number of sub-modules with at least one semiconducting chip attached to the top of an electrically insulating, and a heat conducting substrate with a thermal expansion coefficient matching that of the chip. Each submodule has a substrate with a cooler made from a good thermal conductor. The cooler is embedded in the underside of the substrate. A solder layer is used for attaching the at least one semiconductor chip to a metallization of the substrate.

EP 2 804 209 A1 relates to packaging of electronic components and is concerned with implementation of Ag sintering, and in particular with the challenge that softer parts in an assembly like emitter contacts may be difficult to sinter as they bend along the underlying topology of the substrate and the chip.

US 6,002,163 A is concerned with the electrical relocation of device top pads to the bottom of a device, in particular for the fabrication of arrays of devices, such as imaging (viewing) or display devices.

US 2018/350780 A1 discloses that an electronic device package includes a semiconductor chip having a contact pad on a main face of the semiconductor chip, a contact element disposed on the contact pad, a dielectric layer disposed on the semiconductor chip and the contact element, and an encapsulant disposed onto the dielectric layer.

US 2019/006260 A1 relates to a method of manufacturing a package, wherein the method comprises a forming a chip carrier by covering a thermally conductive and electrically insulating core on both opposing main surfaces thereof at least partially by a respective electrically conductive layer by brazing the respective electrically conductive layer on a respective one of the main surfaces; a mounting at least one electronic chip on the chip carrier; an electrically coupling an electrically conductive contact structure with the at least one electronic chip; and an encapsulating part of the electrically conductive contact structure, and at least part of the chip carrier and of the at least one electronic chip by a mold-type encapsulant.

With increasing demands for power density, it is desirable to increase the current rating of such power electronics modules. Increasing the power density can be achieved, for example, by the development and introduction of new chip technologies providing a reduction of conduction and switching losses of the individual semiconductor power devices during operation. However, the development of new chip technologies and their largescale manufacturing is very time consuming and costly, and therefore provides more of a long-term perspective. Accordingly, other means of increasing a current rating of a power electronics module are desirable.

Embodiments of the disclosure relate to power electronics modules and methods for their manufacturing enabling an increased current rating of a power electronics module with a given size or, a smaller size of a power electronics module with a given current rating. This disclosure shows an alternative method with low effort to enhance or optimize the current capability.

The invention is defined by the attached set of claims. Further details of the disclosed methods, devices and system are provided in the following, which are helpful for understanding the claimed invention.

According to one aspect, a power electronics module comprises a substrate with at least a first metallization area, a first group of power electronic devices arranged in the first metallization area, and a common, uninterrupted joining layer arranged between the first metallization area and the first group of power electronic devices. The first group comprising a plurality of power electronic devices, and the common, uninterrupted joining layer establishes a mechanical and an electrical contact between the first metallization area and the first group of power electronic devices.

Among others, the inventors have found that, by omitting or reducing a distance between power electronic devices and joining a plurality of power electronic devices using a common, uninterrupted joining layer to a single metallization area, a total active area of the power electronic devices arranged on a power electronics module of a given size can be increased, thereby also increasing a current rating of the power electronic devices. While the space on a substrate available for positioning of power electronic devices, such as semiconductor chips, is limited, it can be better utilized by joining multiple power electronic devices using a common, uninterrupted joining layer. This is in contrast to the joining of each power electronic device separately using a separate joining layer, where space is lost due to spaces between individual power electronic devices.

In the claimed power electronics module, each one of the power electronic devices of the first group is arranged directly adjacent to at least one other power electronic device of the first group. In other words, the power electronic devices of the first group are arranged essentially without any gap, or at least a strongly reduced gap, between them, thus maximizing the use of available mounting space. By removing unused space between power electronic devices, the size of the power electronic devices, and consequently the active area can be increased. In particular, when power electronic devices, such as semiconductor chips, can be arranged very close to each other without significant empty space between them, an optimal use of the available surface area of the substrate can be obtained.

In the claimed power electronics module, the power electronic devices are self-aligned and the distance between adjacent power electronic devices of the first group is smaller than 1 mm, for example smaller than 0.5 mm. Such distances cannot be obtained using conventional mounting techniques, when power electronic devices are aligned and mounted using separate joining layers.

According to at least one implementation, the first metallization area comprises a subarea covering a part of the first metallization area and/or the substrate, and the common, uninterrupted joining layer covers essentially the entire subarea.

The area covered by the common, uninterrupted joining layer may exclude any space required for alignment of the group of power electronic devices. The subarea may represent a substantial part of the first metallization area or the substrate, such as the entire area available for placement of power electronic devices. For example, it may represent more than 25, 50 or 75 percent of the main surface area of the first metallization area or the substrate. The subarea may be a rectangular area or an area with any other geometry defined by the power electronic devices to be placed on the power module. For example, the subarea may be a largest rectangular part of the first metallization area. The subarea may exclude one or more smaller parts of the first metallization area configured for interconnecting the power electronic devices and/or for further components of the power electronics modules.

According to different implementations, the power electronic devices of the first group may be joined to the first metallization area using different joining techniques, including soldering or diffusion soldering.

In the claimed power electronics module, the power electronic devices are soldered to the substrate, and a solder layer acts as the common, uninterrupted joining layer. Moreover, due to the physical properties of a soldering process, a distance between neighboring power electronic devices of the first group is defined by a solder meniscus. This effectively enables a self-alignment of the power electronic devices.

According to at least one implementation, the power electronic devices of the first group comprise semiconductor chips, such as MOSFETs, MISFETs, JFETs, IGBTs, or diodes.

According to at least one implementation, each one of the semiconductor chips may comprise at least two terminals, and the terminals of each one of the semiconductor chips may be connected electrically in parallel. Combining multiple semiconductor chips in parallel enables a high current rating.

According to different implementations, the power electronic devices of the first group may be of the same type, or may be of two or more different types. For example, a combination of one or more protective or free-wheeling diodes and one or more transistor or switching devices may be arranged on the first metallization area to form a hybrid power electronics module.

According to another aspect, a method for manufacturing a power electronics module according to claim 8 is provided.

Depending on the used joining technique, e.g. soldering, diffusion soldering, different processing steps may be performed to process and join the plurality of power electronic devices of the first group together, thereby lowering manufacturing cost and improving yield.

The present disclosure comprises several aspects of a power electronics module and methods for its manufacturing. Every feature described with respect to one of the aspects is also disclosed herein with respect to the other aspects, even if the respective feature is not explicitly mentioned in the context of the specific aspect.

The accompanying figures are included to provide a further understanding. In the figures, elements of the same structure and/or functionality may be referenced by the same reference signs. It is to be understood that the embodiments shown in the figures are illustrative representations and are not necessarily drawn to scale.
Figure 1 shows a schematic cross-section through a power electronics module with a common, uninterrupted joining layer.
Figure 2 shows a top view of a power electronics module comprising five power electronic devices with a common, uninterrupted joining layer.
Figures 3 and 4 show different views of a solder fixture used for manufacturing a power electronics module in accordance with embodiments of the present invention.
Figures 5 to 9 show a method for manufacturing a power electronics module by soldering in accordance with an embodiment of the present invention.
Figures 10 and 11 show a method for manufacturing a conventional power electronics module by soldering.
Figures 12 to 15 show a method for manufacturing a power electronics module by sintering, which is not covered by the attached set of claims.

While the disclosure is amenable to various modifications and alternative forms, specifics thereof are shown by way of example in the figures and will be described in detail below. It should be understood, however, that the intention is not to limit the disclosure to the particular embodiments described. On the contrary, the intention is to cover all modifications, equivalents, and alternatives falling within the scope of the invention as defined by the appended set of claims.

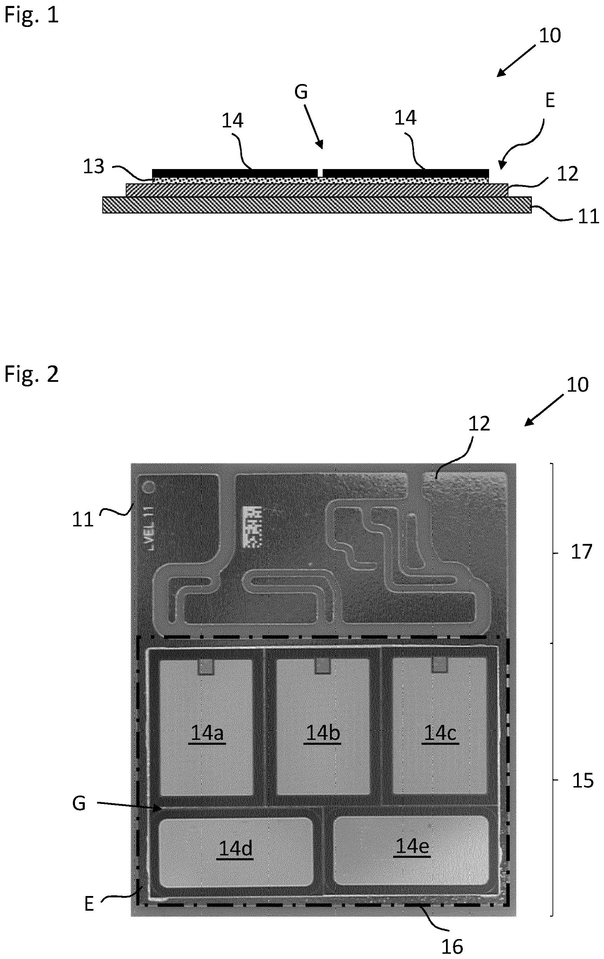

Figure 1 shows, in a schematic manner, a cross-section through a power electronics module 10. The power electronics module 10 comprises a substrate 11 with a first metallization area 12 on one of its main surfaces. For example, the substrate 11 may be a ceramic substrate with a metallization layer formed on one side. A common, uninterrupted joining layer 13 is formed on a surface of the first metallization area opposite the substrate 11. As detailed later, the joining layer 13 is a solder layer or a layer prepared by diffusion soldering. On top of the joining layer 13, a group comprising two power electronic devices 14 is arranged. The group of power electronic devices 14 may comprise at least one semiconductor power diode and/or at least one semiconductor power transistors. The joining layer 13 is uninterrupted in the sense that it does not comprise any intentional gaps and/or provides a direct electrical path between the power electronic devices 14 of the same group, irrespective of an electrical path provided by the first metallization area 12.

Attention is drawn to the fact that a remaining gap G between the two power electronic devices 14 is very small. That is to say, the power electronic devices 14 are arranged more or less directly adjacent to one another in the first metallization area 12. In terms of absolute distance, this may mean that the remaining gap G between the two power electronic devices 14 is smaller than 1 mm, for example 0.5 mm or less. In terms of relative distance, this may mean that the remaining gap G between the two power electronic devices 14 is smaller than 10% or 50 of the width and/or length of the adjacent power electronic devices 14.

Such distances between adjacent power electronic devices 14 cannot be achieved using conventional manufacturing methods, wherein each power electronic device 14 is joined to a metallization area using a separate joining layer 13 as detailed later. Inversely, this means that the joining layer 13 is substantially continuous, and preferably has no gap in an area located between two adjacent power electronic devices 14. Put differently, the joining layer 13 is formed from a common body of joining material. For example, a single piece of material, such as a single solder preform, may be used. Alternatively, a paste-like joining material, such as solder paste, may be applied by dispensing or printing it in a continuous or patterned shape, such as a cross, snowflake, or multiple dots. A continuous joining layer 13 is formed by putting the power electronic devices 14 on the previously dispensed joining material.

Figure 2 shows a top view of a power electronics module 10 with a total of five power electronic devices 14a to 14e, for three IGBTs (or other type of transistors) and two diodes. A first part 15, in Figure 2 the lower part, covers a substantial part of the substrate 11, e.g. more than 50 percent of the total surface of the substrate 11, and comprises an essentially rectangular subarea 16, indicated using a dashed line, of a first metallization area 12.

In the depicted embodiment, the subarea 16 represents the largest rectangular subarea of the first metallization area 12. A large proportion of the subarea 16, e.g. more than 95 percent, is covered by the five power electronic devices 14a to 14e. Only a remaining outer area of the subarea 16 near the outer edges of the five power electronic devices 14a to 14e is left uncovered. A smaller, second part 17 of the substrate 11, in Figure 2 the upper part, may comprise further parts of the first metallization area and further metallization areas. For example, metal traces used for connecting contact surfaces on the back side of the power electronic devices 14a to 14e and/or for connecting the power electronics modules 10 to other components or for joining of other electronic devices like sensor devices, passive device, control devices may be provided. The proportion of the subarea 16 can be at least 80 to 85 percent in some other variants of the power electronics module, e.g. when the shape of the subarea is other than the rectangular geometrical shape or when the current rating requirement is lower.

In other embodiments, further metallization areas and/or subareas may be provided. For example, in a half-bridge used for an inverter module, two different metallization areas may be provided for placement of one or more high-side group and one or more low-side group of power electronic devices, respectively (not shown). For multi-phase inverters, further metallization areas and corresponding groups of power electronic devices may be provided. In such configurations, one or more respective subareas for placement of power electronic devices may only cover a smaller part of the substrate's surface, but may still represent the largest continuous geometrical shape, such as a rectangle, of the respective metallization.

In the embodiment shown in Figure 2, the individual power electronic devices 14a to 14e touch each other or are separated only by a very narrow gap caused by the respective joining technique, as detailed below. In the embodiment shown in Figure 2, the width of remaining gap G between the individual power electronic devices 14 is smaller than a width of a remaining outer edge E between the outside circumference of the first group of power electronic devices 14 and the respective outer circumference of the subarea 16.

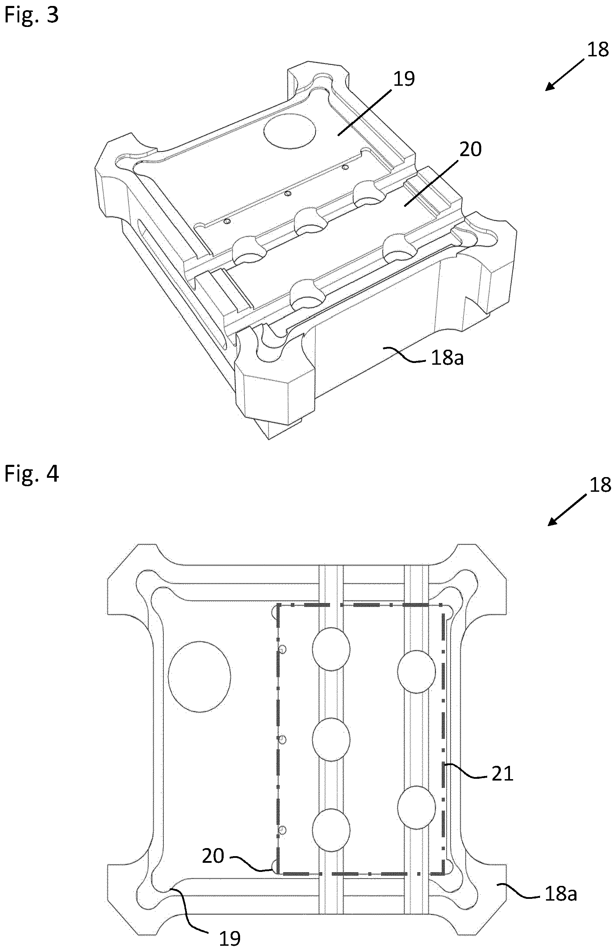

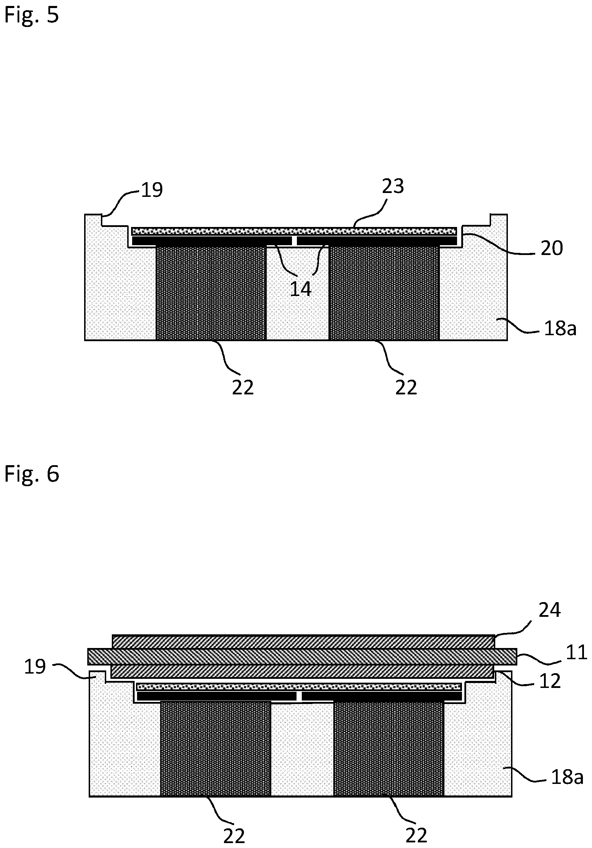

Figures 3 to 9 show how such a power electronics module may be formed by soldering. At first, a modified solder fixture 18 is explained with reference to Figures 3 and 4, before individual phases of a related manufacturing process are explained with reference to Figures 5 to 9.

Figures 3 and 4 show a perspective and a plane view of a first part 18a of the solder fixture 18, respectively. As can be best seen in Figure 3, the first part 18a of the solder fixture 18 comprises a number of depressions for holding the components of power electronics module 10. In particular, a larger, relatively shallow first recess 19 corresponds to the outer circumference of the substrate 11 and/or the metallization areas formed thereon, and serves to hold the substrate 11 during soldering.

A smaller, slightly deeper, second recess 20 is formed within the first recess 19, and is configured to hold a plurality of power electronic devices 14. In the described example, the second recess 20 is configured to hold the five power electronic devices 14a to 14e previously shown in Figure 2 and a common solder preform, as explained later. While only a single second recess 20 configured for holding a single group of power electronic devices 14 is shown in Figures 3 and 4, fixtures 18 comprising several second recesses 20 for multiple groups arranged on the same or different metallization areas 12 are also envisioned.

The first part 18a of the solder fixture 18 comprises a number of further depressions, openings and other structural features that facilitate insertion and removal of the various components into and out of the solder fixture 18, and for accommodating weights for pushing down any power electronic devices 14 placed therein. For the sake of brevity, these are not described in detail here.

In the top view of Figure 4, a rectangular area 21 formed by the second recess 20 is highlighted using a dashed line. Attention is drawn to the fact that the edges of the second recess 20 corresponding to the rectangular area 21 serve to align all of the power electronic devices 14 and the common solder preform together. In contrast, no internal dividing or alignment features are provided between the positions of the individual power electronic devices 14a to 14e. Avoidance of such internal protrusions increases the space available for placement of the power electronic devices 14. Further attention is drawn to the fact that the rectangular area 21 formed within the second recess 20 essentially corresponds to or is only smaller by a relatively small fraction, e.g. a distance corresponding to a solder meniscus and/or needed for alignment, than the subarea 16 of the first metallization area 12.

Figure 5 shows, in a schematic manner, a first stage in the manufacturing of a power electronics module 10. At this stage, multiple power electronic devices 14 have been placed in a common recess 20, from which only two are visible in the cross-section of Figures 5 to 9. Below each one of the power electronic devices 14, a corresponding weight 22 is arranged, which may be a loose part or may be attached to the first part 18a of the solder fixture 18 in a movable manner.

In the described embodiment, above the two power electronic devices 14, a single, continuous solder preform 23 is placed. Due to its larger size and the fact that only a single solder preform 23 needs to be placed in the solder fixture 18, handling of the preform 23 and thus the entire manufacturing process may be simplified. The solder preform 23 covers corresponding contact surfaces of the two power electronic devices 14 and essentially extends over the entire widths of the second recess 20. Accordingly, the same solder preform may be used, irrespective of the individual size of the used power electronic devices 14. For example, the same solder preform 23 may be used to attach two full-size or four half-size chips to the same metallization area 12. Attention is drawn once again to the fact that no separating protrusion is present between the two power electronic devices 14.

Figure 6 shows a further stage in the manufacturing process. At this stage, a double-sided substrate 11 comprising a first metallization area 12 on the first side and a second metallization area 24 arranged on the opposite, second side of the substrate 11 is placed in the first part 18a of the solder fixture 18. For example, in a power module, the first side may correspond to a backside, and the second side may correspond to a front side of the substrate 11. In the depicted embodiment, the first metallization area 12 is placed in the first recess 19 surrounding the second recess 20 such that a subarea of the first metallization area 12, for example the subarea 16 shown in Figure 2, is aligned with the power electronic devices 14.

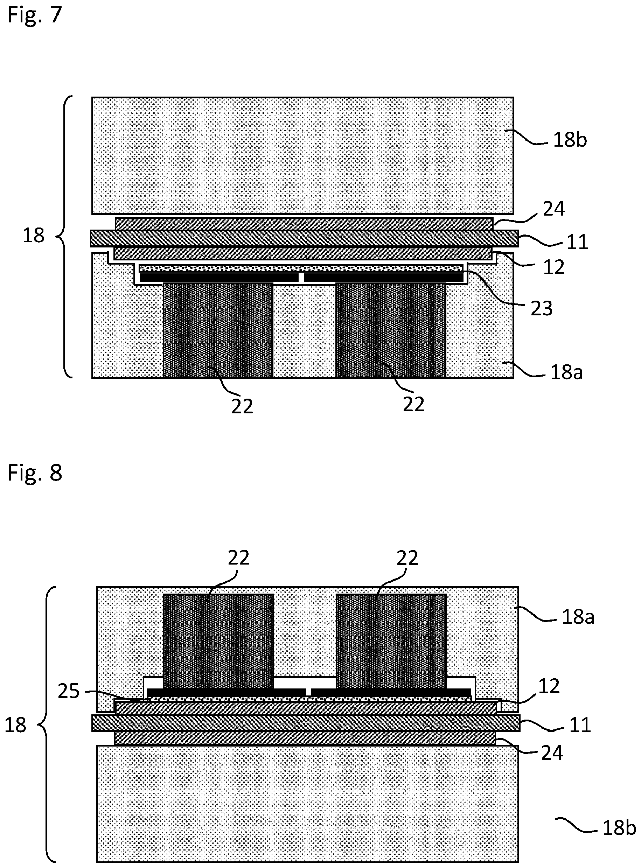

At a next stage, shown in Figure 7, a second part 18b of the solder fixture 18 (fixture bottom plate) is placed on top of the substrate 11, i.e. the second metallization area 24, to close the solder fixture 18.

Thereafter, as shown in Figure 8, the closed solder fixture 18 comprising the first part 18a and the second part 18b is flipping, such that the weights 22 press the respective power electronic devices 14 against the first metallization area 12. At this stage, the solder preform 23 is heated or otherwise liquefied, resulting in a layer of liquid solder material 25.

Optionally, a process gas or liquid, such as hydrogen, or formic acid may be applied during soldering, to support or enable a chemical reduction of the solder material. For example, hydrogen or formic acid may be used for reduction of the solder material of the solder preform 23. Alternatively, or additionally, an inert gas like nitrogen may be applied during at least phases of the joining process.

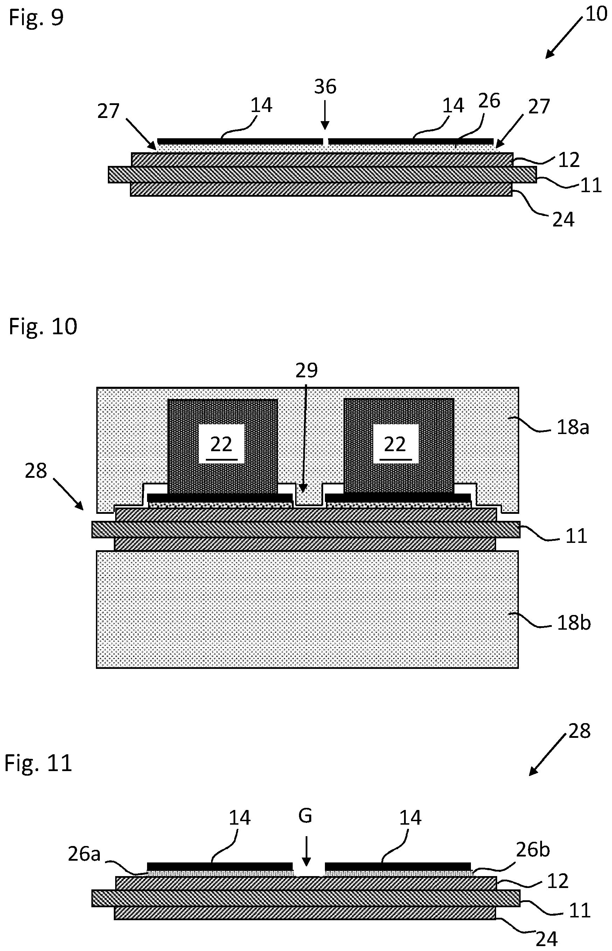

Once the soldering process is complete, the solidified solder material 25 forms a common, uninterrupted solder layer 26 as shown in Figure 9. The thickness of the solder layer 26 may vary to a small extend in areas below the power electronic devices 14 and neighbouring areas, e.g. by a limited overflow of the soldering material into the gap G or towards the edge E. Nonetheless, such a solder layer 26 may be described as homogenous, as it is formed in a single rather than several successive soldering steps.

Thereafter, the solder fixture 18 can be removed, with the individual power electronic devices 14 being mechanically and electrically attached to the first metallization area 12. Moreover, the solder layer 26 may also serve as a thermal connection between the power electronic devices 14 and the substrate 11, e.g. for cooling of the power electronic devices 14. Due to the uninterrupted nature of the common joining layer 13 and/or the larger total surface area of the power electronic devices 14, the thermal capabilities of the resulting power electronics module 10 may also be improved, for example, by achieving a more uniform heat distribution.

As can be seen in Figure 9, due to the surface tension of the liquid solder material, the individual power electronic devices 14 are essentially self-aligned by a solder meniscus 27 formed at the periphery of power electronic devices 14, e.g. by merging with the meniscus of an adjacent power electronic device 14, indicated by a recess 36 in the solder layer 26 in a remaining, internal gap between the power electronic devices 14, and a clear meniscus 27 on the outer periphery of the group of power electronic devices 14. In this way, the physical properties of the solder material itself provides an alignment aid, further alleviating the need for internal protrusions within the second depression 20 of the solder fixture 18.

While a conventional soldering process has been described, more advanced soldering techniques, such as diffusion soldering may also be used accordingly. In this case, rather than weights 22, a controlled pressure may be applied to the power electronic devices 14, e.g. by corresponding fixtures.

Moreover, in another embodiment, instead of placing a solder preform 23 in the common recess 20, solder paste is coated on a surface of the first metallization area 12. For example, a subarea intended for the placement of power electronic devices 14 may be covered with a patterned layer of a viscous solder paste by printing or coating or dispensing. The power electronic devices 14 of the first group are then mounted, for example, using a pick-and-place process and a subsequent thermal process, such as reflow soldering or another bonding technique, resulting in a common, uninterrupted solder layer 26 as described above. In this case, use of a fixture for holding the power electronic devices 14 is optional, as the power electronic devices 14 may be held in place before and during soldering by the solder paste.

Finally, in case more than one group of power electronic devices 14 shall be mounted, each group can be mounted separately, as described below with respect to sintering.

Figures 10 and 11 show an intermediate stage and resulting power electronics module 28 formed by an alternative, more conventional method of attaching two power electronic devices 14 to a substrate 11 with a first metallization area 12.

As shown in Figure 10, each one of the power electronic devices 14 is individually aligned on all sides before and during soldering. To this end, a protrusion 29 is present in a first part 18a of a solder fixture 18, separating the power electronic devices 14 and individual solder preforms from each other. Accordingly, two separate solder preforms 23a and 23b must be placed in each one of two corresponding recesses 20a and 20b. During the soldering process, the power electronic devices 14 as well as the solder materials remain separated by the protrusion 29.

Accordingly, as is shown in Figure 11, two separate solder layers 26a and 26b are formed, which are separated from one another (except for unintentional solder overflows) by a corresponding gap G, which typically exceeds 1 mm in width. The surface area of the substrate 11 and corresponding part of the first metallization area 12 according to the gap G is lost for the placement of active components, so the chip sizes and consequently the active areas of the chips must be smaller. This leads to a lower current rating of the power electronics module 28 compared to the power electronics module 10 of Figure 9.

That is to say, when using a common, uninterrupted joining layer 13, larger and/or more numerous chips forming the power electronic devices 14 may be placed in common metallization area 12 of a given size. This results in a larger total active area of the chips, which in turn results in a higher current capability or power density. Inversely, if the number and size of the individual power electronic devices 14 is fixed, a smaller substrate 11 with a smaller metallization area 12 may be used to obtain the same current capability. This may result in a miniaturization and reduction of cost.

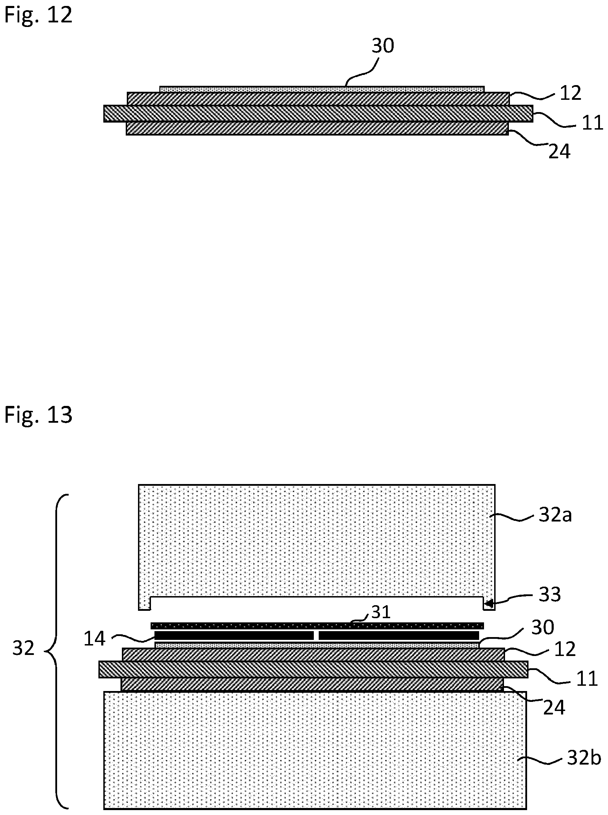

Figures 12 to 15 show, in a schematic manner, different stages of a manufacturing method for a power electronics module 10 based on sintering, which is not covered by the attached set of claims.

At a first stage, shown in Figure 12, a layer of sinter material is provided on a first metallization area 12 of a double-sided substrate 11. As an example, sintering preform 30 may be placed on the first metallization area 12. Alternatively, a layer of sinter material may be applied, for example by printing, in a corresponding area of the first metallization area 12.

At a next stage, shown in Figure 13, multiple power electronic devices 14, forming a group of power electronic devices to be sintered, are placed on the sintering preform 30. For example, a pick and place procedure may be used to place individual power semiconductor chips on the sinter preform 30.

The substrate 11 with the aligned power electronic device 14 may be placed in a sinter press. In an optional step, a protective foil 31 may be placed on top of the power electronic devices 14 to provide mechanical protection and/or protection against contaminations during sintering, e.g. to protect corresponding electrodes or other parts of the upper side of the power electronic devices 14. For example, a first part 32a of a sintering fixture 32 may be placed over the protective foil 31, the power electronic devices 14, the sintering preform 30 and the double-sided substrate 11 as shown in Figure 13. As shown in Figure 13, the first part 32a of a sintering fixture 32 comprises a recess 33 for laterally holding and/or aligning the power electronic device 14 before and during sintering. On the opposite side of the double-sided substrate 11, i.e. below the second metallization area 24, a second part 32b of the sintering press or sintering fixture 32 is arranged.

While the term "sintering fixture" is used here and a profiled sintering fixture 32 is shown for better understanding, attention is drawn to the fact that, in its simplest form, sintering may be performed between two arbitrary, flat surfaces. That is to say, the recess 33 represents an optional feature for the sintering process.

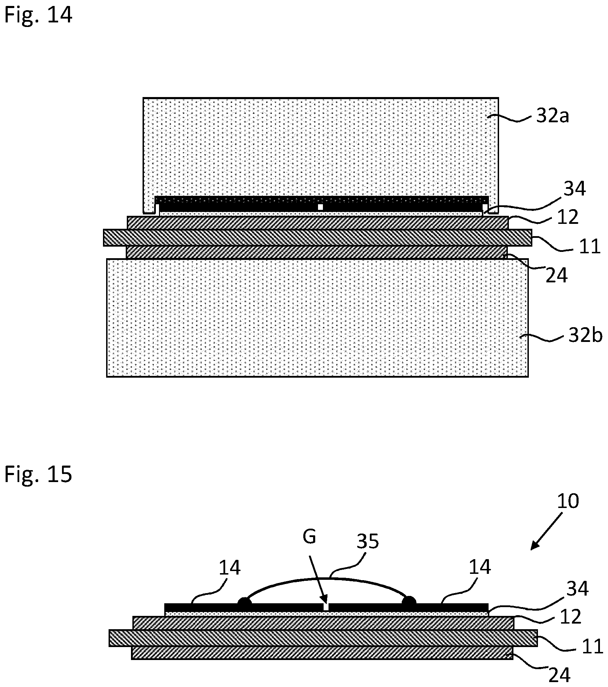

As shown in Figure 14, the two opposite surfaces used for sintering are closed and pressed against each other to sinter the material of the sinter preform 30 into an essentially uniform sinter layer 34 between the power electronic devices 14 and the first metallization area 12.

While sintering based on mechanical pressing has been described above, other known sintering processes based on heat and/or a processing atmospheric may also be used or combined with a mechanical sintering process. For example, sintering may be performed in an atmosphere consisting of an inert gas to avoid unwanted chemical reactions.

As detailed above, the sintering layer 34 provides both a mechanical and electrical connection between the adjoining parts, and may also provide a thermal connection.

Once the sintering is complete, as shown in Figure 15, the sintering fixture 32 may be removed and further processing steps may take place. For example, as also shown in Figure 15, one or more bond wires 35 may be connected to electrical contacts arranged on the opposite, upper surface of the individual power electronic devices 14, for example between different power electronic devices 14 as shown in Figure 15, or between a power electronic device 14 and a metallization area (not shown). In this way, for example, a relatively large number of power electronic devices 14 may be connected electrically in parallel.

In the scenario shown in Figures 1 to 9 and Figures 12 to 15, a single, continuous and homogenous preform is used as solder or sinter material layer, respectively, which covers a large part of the outer surface of the first metallization area 12.

However, in other embodiments (not shown), different groups of power electronic devices 14 may be soldered tc a common metallization area 12 in successive stages. In this case, a single preform or area covered with joining material, such as a solder paste may only cover a part of the first metallization area 12, which corresponds to a respective first group of power electronic devices 14.

Moreover, especially in the case of sintering (which does not fall within the scope of the attached claims), depending on the joining materials and joining processes, a stack of multiple preforms and/or multiple layers of joining materials may be used.

Moreover, although not shown in the drawings, the above solder or sintering processed may be repeated for the second main surface of the substrate, thereby forming power electronics modules 10 carrying power electronic devices 14 on the two opposite metallization areas 12 and 24.

The embodiments shown in Figures 3 9 as stated represent examples of improved power electronics modules 10 and methods for their manufacturing. Therefore, they do not constitute a complete list of all embodiments according to the improved devices and methods as defined by the attached set of claims. Actual devices and methods may vary from the embodiments shown in terms of arrangements, devices and processing steps, for example.

For example, while not shown in the attached figures and not covered by the attached set of claims, a common, uninterrupted joining layer 13 may also be formed using an adhesive layer. For example, a preferably electrically conductive, double-sided adhesive tape may be placed on an upper surface of a first metallization area 12 of a substrate 11. Thereafter, individual power electronic devices 14 forming a group of power electronic devices can be placed on the opposite second adhesive surface of the double-sided adhesive tape, e.g. by a pick and place process. Alternatively, a preferably electrically conductive, typically patterned layer of liquid or viscous glue, such as a silver glue, may be dispensed, for example in a patterned layer, by scribing, dispensing, printing or coating the liquid or viscous glue on the surface of the first metallization area 12, or on corresponding contact surfaces of a plurality of power electronic devices 14 held in a common fixture similar to the first part 18a of the solder fixture 18 shown in Figures 3 and 4. Thereafter, the first metallization area 12 may be aligned with the group of power electronic devices 14. As a result, the liquid or viscous glue forms a homogenous layer. After placement of the power electronic devices 14 the glue may be cured using an appropriate process, such as heating or evaporating of a solvent, resulting an essentially homogenous, uninterrupted joining layer 13.

## Claims

1. A power electronics module (10), comprising:
- a substrate (11) with at least a first metallization area (12);
- a first group of power electronic devices (14) arranged in the first metallization area (12), wherein the first group comprises a plurality of power electronic devices (14); and
- a common, uninterrupted joining layer (13) of solder material (25) arranged between the first metallization area (12) and the first group of power electronic devices (14), wherein the common, uninterrupted joining layer (13) establishes a mechanical and an electrical contact between the first metallization area (12) and the first group of power electronic devices (14);
- wherein each one of the power electronic devices (14) of the first group is arranged directly adjacent to at least one other power electronic device (14) of the first group;
- wherein the individual power electronic devices (14) are self-aligned during a soldering process for joining the power electronic devices (14) to the metallization area (12) by a solder meniscus (27) formed at the periphery of each power electronic device (14), the solder meniscus of adjacent ones of the power electronic devices (14) merging such that the solder layer (26) comprises a recess (36) in an internal gap between adjacent ones of the power electronic devices (14);
- wherein the first group of power electronic devices comprises a clear meniscus (27) at its outer periphery; and
- wherein a distance between adjacent power electronic devices (14) of the first group is smaller than 1 mm.

2. The power electronics module (10) of claim 1, wherein the distance between adjacent power electronic devices (14) of the first group is smaller than 0.5 mm.

3. The power electronics module (10) of claim 1 or 2, wherein the first metallization area (12) comprises a rectangular subarea (16) covering more than 50 percent, preferably more than 75 percent, of a main surface of the first metallization area (12) and/or the substrate (11), and the common, uninterrupted joining layer (13) covers the entire rectangular subarea (16).

4. The power electronics module (10) of claim 3, wherein a distance between an outer circumference of the rectangular subarea (16) and an outer edge of a closest power electronic device (14) of the first group is larger than a distance between adjacent power electronic devices (14) of the first group.

5. The power electronics module (10) of any one of claims 1 to 4, wherein the power electronic devices (14) of the first group are semiconductor chips, comprising at least one of a MOSFET, a MISFET, a JFET, an IBGT or a diode.

6. The power electronics module (10) of any one of claims 1 to 5, wherein each one of the semiconductor chips comprises at least two terminals, and the terminals of each one of the chips are connected electrically in parallel.

7. The power electronics module (10) of any one of claims 1 to 6, wherein the first group of power electronic devices (14) comprises at least two different types of power electronic devices arranged in the first metallization area (12) .

8. A method for manufacturing a power electronics module (10), comprising:
- arranging a layer of solder material (25) between a first metallization area (12) of a substrate (11) and respective contact surfaces of a first group of power electronic devices (14), wherein the first group comprises a plurality of power electronic devices (14), and each one of the power electronic devices (14) of the first group is arranged directly adjacent to at least one other power electronic device (14) of the first group; and
- forming a common, uninterrupted solder layer (26) from the solder material (25) by applying a weight or controlled pressure to the power electronic devices (14) of the first group of power electronic devices (14), wherein:
- the common, uninterrupted solder layer (26) establishes a mechanical and an electrical contact between the first metallization area (12) and the first group of power electronic devices (14);
- during the step of forming the common, uninterrupted solder layer (26), a solder meniscus (27) of the solder material is formed at the periphery of the power electronic devices (14), such that the individual power electronic devices (14) are self-aligned due to the surface tension of the liquid solder material; whereby the solder meniscus of adjacent ones of the power electronic devices (14) merges such that a recess (36) is formed in the solder layer (26)in a remaining, internal gap between the power electronic devices (14), and a clear meniscus (27)is formed on the outer periphery of the group of power electronic devices; and
- a distance between adjacent power electronic devices (14) of the first group is smaller than 1 mm.

9. The method of claim 8, wherein the layer of solder material (25) comprises a solder preform (23), and the method specifically comprises:
- placing the first group of power electronic devices (14) in a common recess (20) of a first part (18a) of a solder fixture (18), the common recess (20) being free of protrusions for separating power electronic devices (14) of the first group;
- placing the solder preform (23) on the contact surfaces of the power electronic devices (14) of the first group;
- placing the substrate (11) with the at least one metallization area (12) on the solder preform (23);
- closing the solder fixture (18); and
- applying a solder process to transform the continuous solder preform (23) to the common, uninterrupted solder layer (26).

10. The method of claim 8, wherein the layer of joining material comprises a layer of solder paste, and the method specifically comprises:
- coating at least a part of the first metallization area (12) with a layer of solder paste;
- placing the first group of power electronic devices (14) on the layer of solder paste; and
- applying a solder process to transform the solder paste to the common, uninterrupted solder layer (26).

## Patentansprüche

1. Leistungshalbleitermodul (10), umfassend:
- ein Substrat (11) mit mindestens einem ersten Metallisierungsbereich (12);
- eine erste Gruppe von Leistungshalbleiterbauelementen (14), die in dem ersten Metallisierungsbereich (12) angeordnet sind, wobei die erste Gruppe eine Mehrzahl von Leistungshalbleiterbauelementen (14) umfasst; und
- eine gemeinsame, unterbrechungsfreie Verbindungsschicht (13) aus Lotmaterial (25), das zwischen dem ersten Metallisierungsbereich (12) und der ersten Gruppe von Leistungshalbleiterbauelementen (14) angeordnet ist, wobei die gemeinsame, unterbrechungsfreie Verbindungsschicht (13) einen mechanischen und einen elektrischen Kontakt zwischen dem ersten Metallisierungsbereich (12) und der ersten Gruppe von Leistungshalbleiterbauelementen (14) herstellt;
- wobei jedes der Leistungshalbleiterbauelemente (14) der ersten Gruppe direkt benachbart zu mindestens einem anderen Leistungshalbleiterbauelement (14) der ersten Gruppe angeordnet ist;
- wobei die einzelnen Leistungshalbleiterbauelemente (14) während eines Lötprozesses zum Verbinden der Leistungshalbleiterbauelemente (14) mit dem Metallisierungsbereich (12) durch einen an der Peripherie jedes Leistungshalbleiterbauelements (14) gebildeten Lötmeniskus (27) selbstjustierend sind, wobei der Lötmeniskus benachbarter Leistungshalbleiterbauelemente (14) so ineinanderfließt, dass die Lotschicht (26) eine Aussparung (36) in einem inneren Spalt zwischen benachbarten Leistungshalbleiterbauelementen (14) umfasst;
- wobei die erste Gruppe von Leistungshalbleiterbauelementen an ihrer äußeren Peripherie einen freien Meniskus (27) umfasst; und
- wobei ein Abstand zwischen benachbarten Leistungshalbleiterbauelementen (14) der ersten Gruppe kleiner als 1 mm ist.

2. Leistungshalbleitermodul (10) nach Anspruch 1, wobei der Abstand zwischen benachbarten Leistungshalbleiterbauelementen (14) der ersten Gruppe kleiner als 0,5 mm ist.

3. Leistungshalbleitermodul (10) nach Anspruch 1 oder 2, wobei der erste Metallisierungsbereich (12) einen rechteckigen Teilbereich (16) umfasst, der mehr als 50 Prozent, vorzugsweise mehr als 75 Prozent, einer Hauptoberfläche des ersten Metallisierungsbereichs (12) und/oder des Substrats (11) bedeckt, und die gemeinsame, unterbrechungsfreie Verbindungsschicht (13) den gesamten rechteckigen Teilbereich (16) bedeckt.

4. Leistungshalbleitermodul (10) nach Anspruch 3, wobei ein Abstand zwischen einem Außenumfang des rechteckigen Teilbereichs (16) und einer Außenkante eines nächstgelegenen Leistungshalbleiterbauelements (14) der ersten Gruppe größer als ein Abstand zwischen benachbarten Leistungshalbleiterbauelementen (14) der ersten Gruppe ist.

5. Leistungshalbleitermodul (10) nach einem der Ansprüche 1 bis 4, wobei die Leistungshalbleiterbauelemente (14) der ersten Gruppe Halbleiterchips sind, die mindestens einen MOSFET, einen MISFET, einen JFET, einen IBGT oder eine Diode umfassen.

6. Leistungshalbleitermodul (10) nach einem der Ansprüche 1 bis 5, wobei jeder der Halbleiterchips mindestens zwei Anschlüsse umfasst, und die Anschlüsse jedes einzelnen Chips elektrisch parallelgeschaltet sind.

7. Leistungshalbleitermodul (10) nach einem der Ansprüche 1 bis 6, wobei die erste Gruppe von Leistungshalbleiterbauelementen (14) mindestens zwei verschiedene Typen von Leistungshalbleiterbauelementen umfasst, die in dem ersten Metallisierungsbereich (12) angeordnet sind.

8. Verfahren zur Herstellung eines Leistungshalbleitermoduls (10), umfassend:
- Anordnen einer Schicht aus Lotmaterial (25) zwischen einem ersten Metallisierungsbereich (12) eines Substrats (11) und jeweiligen Kontaktoberflächen einer ersten Gruppe von Leistungshalbleiterbauelementen (14), wobei die erste Gruppe eine Mehrzahl von Leistungshalbleiterbauelementen (14) umfasst, und jedes der Leistungshalbleiterbauelemente (14) der ersten Gruppe direkt benachbart zu mindestens einem anderen Leistungshalbleiterbauelement (14) der ersten Gruppe angeordnet ist; und
- Bilden einer gemeinsamen, unterbrechungsfreien Lotschicht (26) aus dem Lotmaterial (25) durch Aufbringen eines Gewichts oder kontrollierten Drucks auf die Leistungshalbleiterbauelemente (14) der ersten Gruppe von Leistungshalbleiterbauelementen (14), wobei:
- die gemeinsame, unterbrechungsfreie Lotschicht (26) einen mechanischen und einen elektrischen Kontakt zwischen dem ersten Metallisierungsbereich (12) und der ersten Gruppe von Leistungshalbleiterbauelementen (14) herstellt;
- während des Schritts des Bildens der gemeinsamen, unterbrechungsfreien Lotschicht (26) ein Lötmeniskus (27) aus dem Lotmaterial an der Peripherie der Leistungshalbleiterbauelemente (14) gebildet wird, so dass die einzelnen Leistungshalbleiterbauelemente (14) aufgrund der Oberflächenspannung des flüssigen Lotmaterials selbstjustierend sind; wobei der Lötmeniskus benachbarter Leistungshalbleiterbauelemente (14) so ineinanderfließt, dass eine Aussparung (36) in der Lotschicht (26) in einem verbleibenden, inneren Spalt zwischen den Leistungshalbleiterbauelementen (14) gebildet wird, und an der äußeren Peripherie der Gruppe von Leistungshalbleiterbauelementen ein freier Meniskus (27) gebildet wird; und
- ein Abstand zwischen benachbarten Leistungshalbleiterbauelementen (14) der ersten Gruppe kleiner als 1 mm ist.

9. Verfahren nach Anspruch 8, wobei die Schicht aus Lotmaterial (25) eine Lötvorform (23) umfasst, und das Verfahren insbesondere umfasst:
- Platzieren der ersten Gruppe von Leistungshalbleiterbauelementen (14) in einer gemeinsamen Aussparung (20) eines ersten Teils (18a) einer Löthalterung (18), wobei die gemeinsame Aussparung (20) frei von Vorsprüngen zum Trennen von Leistungshalbleiterbauelementen (14) der ersten Gruppe ist;
- Platzieren der Lötvorform (23) auf den Kontaktflächen der Leistungshalbleiterbauelemente (14) der ersten Gruppe;
- Platzieren des Substrats (11) mit dem mindestens einen Metallisierungsbereich (12) auf der Lötvorform (23) ;
- Schließen der Löthalterung (18); und
- Anwenden eines Lötprozesses, um die kontinuierliche Lötvorform (23) in die gemeinsame, unterbrechungsfreie Lotschicht (26) zu transformieren.

10. Verfahren nach Anspruch 8, wobei die Schicht aus Verbindungsmaterial eine Schicht aus Lotpaste umfasst, und das Verfahren insbesondere umfasst:
- Beschichten mindestens eines Teils des ersten Metallisierungsbereichs (12) mit einer Schicht aus Lotpaste;
- Platzieren der ersten Gruppe von Leistungshalbleiterbauelementen (14) auf der Schicht aus Lotpaste; und
- Anwenden eines Lötprozesses, um die Lotpaste in die gemeinsame, unterbrechungsfreie Lotschicht (26) zu transformieren.

## Revendications

1. Module d'électronique de puissance (10), comprenant :
- un substrat (11) avec au moins une première zone de métallisation (12) ;
- un premier groupe de dispositifs électroniques de puissance (14) agencés dans la première zone de métallisation (12), le premier groupe comprenant une pluralité de dispositifs électroniques de puissance (14) ; et
- une couche de jonction ininterrompue commune (13) de matériau de brasage (25) agencée entre la première zone de métallisation (12) et le premier groupe de dispositifs électroniques de puissance (14), la couche de jonction ininterrompue commune (13) établissant un contact mécanique et électrique entre la première zone de métallisation (12) et le premier groupe de dispositifs électroniques de puissance (14) ;
- chacun des dispositifs électroniques de puissance (14) du premier groupe étant agencé de façon directement adjacente à au moins un autre dispositif électronique de puissance (14) du premier groupe ;
- les dispositifs électroniques de puissance (14) individuels étant auto-alignés pendant un processus de brasage pour joindre les dispositifs électroniques de puissance (14) à la zone de métallisation (12) par un ménisque de brasage (27) formé au niveau de la périphérie de chaque dispositif électronique de puissance (14), les ménisques de brasage des dispositifs électroniques de puissance adjacents parmi les dispositifs électroniques de puissance (14) fusionnant de telle sorte que la couche de brasage (26) comprenne un évidement (36) dans un espace interne entre des dispositifs électroniques de puissance adjacents parmi les dispositifs électroniques de puissance (14) ;
- le premier groupe de dispositifs électroniques de puissance comprenant un ménisque transparent (27) au niveau de sa périphérie externe ; et
- une distance entre des dispositifs électroniques de puissance (14) adjacents du premier groupe étant inférieure à 1 mm.

2. Module d'électronique de puissance (10) selon la revendication 1, dans lequel la distance entre des dispositifs électroniques de puissance (14) adjacents du premier groupe est inférieure à 0,5 mm.

3. Module d'électronique de puissance (10) selon la revendication 1 ou la revendication 2, dans lequel la première zone de métallisation (12) comprend une sous-zone rectangulaire (16) recouvrant plus de 50 pour cent, préférablement plus de 75 pour cent, d'une surface principale de la première zone de métallisation (12) et/ou du substrat (11), et la couche de jonction ininterrompue commune (13) recouvre la sous-zone rectangulaire (16) tout entière.

4. Module d'électronique de puissance (10) selon la revendication 3, dans lequel une distance entre une circonférence externe de la sous-zone rectangulaire (16) et un bord externe d'un dispositif électronique de puissance (14) le plus proche du premier groupe est supérieure à une distance entre des dispositifs électroniques de puissance (14) adjacents du premier groupe.

5. Module électronique de puissance (10) selon l'une quelconque des revendications 1 à 4, dans lequel les dispositifs électroniques de puissance (14) du premier groupe sont des puces semiconductrices, comprenant au moins un élément parmi un MOSFET, un MISFET, un JFET, un IBGT ou une diode.

6. Module d'électronique de puissance (10) selon l'une quelconque des revendications 1 à 5, dans lequel chacune des puces semiconductrices comprend au moins deux bornes, et les bornes de chacune des puces sont connectées électriquement en parallèle.

7. Module d'électronique de puissance (10) selon l'une quelconque des revendications 1 à 6, dans lequel le premier groupe de dispositifs électroniques de puissance (14) comprend au moins deux types différents de dispositifs électroniques de puissance agencés dans la première zone de métallisation (12).

8. Procédé de fabrication d'un module d'électronique de puissance (10), comprenant :
- l'agencement d'une couche de matériau de brasage (25) entre une première zone de métallisation (12) d'un substrat (11) et des surfaces de contact respectives d'un premier groupe de dispositifs électroniques de puissance (14), le premier groupe comprenant une pluralité de dispositifs électroniques de puissance (14), et chacun des dispositifs électroniques de puissance (14) du premier groupe étant agencé de façon directement adjacente à au moins un autre dispositifs électronique de puissance (14) du premier groupe ; et
- la formation d'une couche de brasage ininterrompue commune (26) à partir du matériau de brasage (25) par application d'un poids ou d'une pression contrôlée aux dispositifs électroniques de puissance (14) du premier groupe de dispositifs électroniques de puissance (14), dans lequel :
- la couche de brasage ininterrompue commune (26) établit un contact mécanique et électrique entre la première zone de métallisation (12) et le premier groupe de dispositifs électroniques de puissance (14) ;
- pendant l'étape de formation de la couche de brasage ininterrompue commune (26), un ménisque de brasage (27) du matériau de brasage est formé au niveau de la périphérie des dispositifs électroniques de puissance (14), de telle sorte que les dispositifs électroniques de puissance (14) individuels soient auto-alignés en raison de la tension de surface du matériau de brasage liquide ; grâce à quoi le ménisque de brasage de dispositifs électroniques de puissance adjacents parmi les dispositifs électroniques de puissance (14) fusionne de telle sorte qu'un évidement (36) soit formé dans la couche de brasage (26) dans un espace interne restant entre les dispositifs électroniques de puissance (14), et qu'un ménisque transparent (27) soit formé sur la périphérie externe du groupe de dispositifs électroniques de puissance ; et
- une distance entre des dispositifs électroniques de puissance (14) adjacents du premier groupe est inférieure à 1 mm.

9. Procédé selon la revendication 8, dans lequel la couche de matériau de brasage (25) comprend une préforme de brasage (23), et le procédé comprend spécifiquement :
- le placement du premier groupe de dispositifs électroniques de puissance (14) dans un évidement commun (20) d'une première partie (18a) d'un appareil de brasage (18), l'évidement commun (20) étant exempt de saillies pour séparer des dispositifs électroniques de puissance (14) du premier groupe ;
- le placement de la préforme de brasage (23) sur les surfaces de contact des dispositifs électroniques de puissance (14) du premier groupe ;
- le placement du substrat (11) avec l'au moins une zone de métallisation (12) sur la préforme de brasage (23) ;
- la fermeture de l'appareil de brasage (18) ; et
- l'application d'un processus de brasage pour transformer la préforme de brasage (23) continue en la couche de brasage ininterrompue commune (26).

10. Procédé selon la revendication 8, dans lequel la couche de matériau de jonction comprend une couche de pâte à braser, et le procédé comprend spécifiquement :
- le revêtement d'au moins une partie de la première zone de métallisation (12) d'une couche de pâte à braser ;
- le placement du premier groupe de dispositifs électroniques de puissance (14) sur la couche de pâte à braser ; et
- l'application d'un processus de brasage pour transformer la pâte à braser en la couche de brasage ininterrompue commune (26).
